# EUROPÄISCHE PATENTSCHRIFT

(11) **EP 1 369 881 B1**
(45) Veröffentlichungstag und Bekanntmachung des Hinweises auf die Patenterteilung: **31.10.2007**
(21) Anmeldenummer: 03012625.4
(22) Anmeldetag: 03.06.2003
(51) Int. Cl.: H01C 7/10, H01C 7/18, H01G 4/38, H01G 4/12

(54) **Elektrisches Vielschichtbauelement**
Electrical multilayer component
Composant électrique multicouche

(30) Priorität: 03.06.2002 DE 10224566
(43) Veröffentlichungstag der Anmeldung: 10.12.2003
(73) Patentinhaber: EPCOS AG, 81669 München (DE)
(72) Erfinder: Mikos, Peter, 8530 Deutschlandsberg (AT); Feichtinger, Thomas, 8010 Graz (AT); Schlick, Horst, 8010 Graz (AT)
(74) Vertreter: Epping - Hermann - Fischer

(56) Entgegenhaltungen:
- DE-A- 19 639 947
- US-A- 5 034 709
- US-A- 5 880 925
- PATENT ABSTRACTS OF JAPAN Bd. 0182, Nr. 77 (E-1554), 26. Mai 1994 (1994-05-26) & JP 6 053077 A (MITSUBISHI MATERIALS CORP), 25. Februar 1994 (1994-02-25)
- PATENT ABSTRACTS OF JAPAN Bd. 0182, Nr. 77 (E-1554), 26. Mai 1994 (1994-05-26) & JP 6 053078 A (MITSUBISHI MATERIALS CORP), 25. Februar 1994 (1994-02-25)

## Beschreibung

Die Erfindung betrifft ein elektrisches Vielschichtbauelement mit einem Grundkörper enthaltend einen Stapel aus übereinanderliegenden Dielektrikumsschichten mit dazwischenliegenden Elektrodenschichten.

Aus der Druckschrift DE 196 39 947 A1 ist ein Vielschichtbauelement der eingangs genannten Art bekannt, bei dem der Grundkörper zwei entlang einer Längsrichtung verlaufende, gegenüberliegende Seitenflächen und mindestens eine Stirnfläche aufweist. Es sind in Längsrichtung des Bauelements nebeneinander angeordnete Vielschichtkondensatoren gebildet. Die Vielschichtkondensatoren haben eine gemeinsame Gegenelektrode, die ihrerseits wieder aus einem Stapel von übereinanderliegenden Elektrodenschichten gebildet sein kann und welche auf der Stirnseite des Bauelements aus dem Bauelement herausgeführt ist.

Das bekannte Bauelement hat den Nachteil, daß es eine relativ kleine Integrationsdichte aufweist, das heißt, daß nur sehr wenige Kondensatoren bezogen auf die von dem Grundkörper in Anspruch genommene Grundfläche in dem Bauelement integriert sind.

Aus US 5,880,925 ist ein Vielschichtbauelement mit einem Vielschichtkondensator bekannt. Dieser weist Elektrodenschichten mit längsseitig herausgeführten Stegen auf, welche mit Außenkontakten kontaktiert sind.

Es ist Aufgabe der vorliegenden Erfindung, ein elektrisches Vielschichtbauelement anzugeben, das eine hohe Integrationsdichte aufweist.

Diese Aufgabe wird gelöst durch ein elektrisches Vielschichtbauelement nach Patentanspruch 1. Vorteilhafte Ausgestaltungen sind den abhängigen Ansprüchen zu entnehmen.

Es wird ein elektrisches Vielschichtbauelement angegeben mit einem Grundkörper enthaltend einen Stapel aus übereinanderliegenden Dielektrikumsschichten, die ein Keramikmaterial mit Varistoreffekt enthalten. Zwischen Dielektrikumsschichten sind Elektrodenschichten angeordnet, welche elektrisch leitfähig sind. Der Grundkörper weist zwei entlang einer Längsrichtung verlaufende, gegenüberliegende Seitenflächen und mindestens eine Stirnfläche auf.

Ferner weist das Bauelement einen ersten Vielschichtkondensator auf, dessen erster elektrischer Kontakt auf der ersten Seitenfläche liegt und dessen zweiter elektrischer Gegenkontakt auf einer Stirnfläche liegt.

Das Bauelement weist noch einen zweiten Vielschichtkondensator auf, dessen erster elektrischer Kontakt auf der zweiten Seitenfläche angeordnet ist und dessen zweiter elektrischer Gegenkontakt auf einer Stirnfläche des Grundkörpers angeordnet ist.

Die ersten elektrischen Kontakte von zumindest zwei Vielschichtkondensatoren sind auf gegenüberliegenden Seitenflächen des Vielschichtbauelements angeordnet. Die zweiten elektrischen Gegenkontakte des ersten und zweiten Kondensators sind dabei nicht auf der gesamten Stirnfläche sondern nur auf Teilbereichen der Stirnfläche angeordnet.

Außerdem ist vorgesehen, dass jeder Vielschichtkondensator mehrere mit seinem ersten elektrischen Kontakt kontaktierte, übereinander angeordnete Elektrodenschichten aufweist.

Das Vielschichtbauelement hat gegenüber den bekannten Vielschichtbauelementen den Vorteil, daß es eine um den Faktor zwei höhere Integrationsdichte aufweist, da entlang einer Längsrichtung des Bauelements immer zwei einander gegenüberliegende Kondensatoren in das Bauelement integriert sind.

Das Vielschichtbauelement hat ferner den Vorteil, daß mit Hilfe der stirnflächenseitig aus dem Grundkörper herausgeführten Kontakte eine interne Verschaltung mehrerer Vielschichtkondensatoren realisiert werden kann. Dadurch reduziert sich der später auf der mit dem Vielschichtbauelement zu bestückenden Platine der Verschaltungs- und Verdrahtungsaufwand, was wiederum Platz auf der Platine einspart. Dadurch, daß die zweiten Kontakte der Kondensatoren jeweils nur einen Teilbereich der Stirnfläche und nicht die gesamte Stirnfläche bedecken, läßt sich bei erfindungsgemäßen Bauelementen besonders gut ein großer Isolationsabstand zwischen den auf den Stirnflächen und auf den Seitenflächen vorhandenen Kontakten realisieren, der z.B. einen elektrischen Durchschlag verhindert. Dies hat zur Folge, daß bei erfindungsgemäßen Bauelementen die auf den Seitenflächen angeordneten ersten Kontakte z.B. näher an die Kante zu den jeweiligen Stirnfläche hin angeordnet werden können, so daß eine höhere Integrationsdichte als bei herkömmlichen Bauelementen möglich ist.

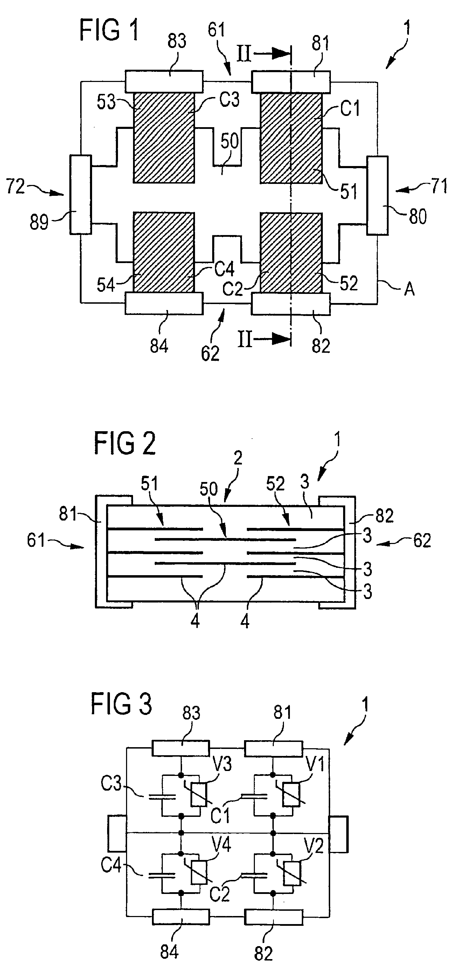

Durch die Kombination von Dielektrikumsschichten, die ein Keramikmaterial mit Varistoreffekt enthalten und der Geometrie der Elektrodenschichten, die im Grundkörper überlappen, so daß ein Kondensatoreffekt resultiert, lassen sich bei erfindungsgemäßen Vielschichtbauelementen besonders einfach Kondensatoren mit Varistoren verschalten (siehe z.B. Fig. 3).

In einer Ausführungsform ist im Grundkörper ein erster Stapel von übereinanderliegenden Elektrodenschichten angeordnet, die an einem ersten Kontakt auf einer ersten Seitenfläche aus dem Grundkörper herausgeführt sind. Dieser erste Stapel bildet zusammen mit einem weiteren Stapel aus übereinanderliegenden Elektrodenschichten, die auf einer Stirnfläche aus dem Grundkörper herausgeführt sind, einen ersten Vielschichtkondensator.

Es ist ferner im Grundkörper ein zweiter Stapel von übereinanderliegenden Elektrodenschichten angeordnet, die an einem zweiten Kontakt aus dem Grundkörper herausgeführt sind. Der zweite Kontakt auf der zweiten Seitenfläche des Grundkörpers angeordnet. Der zweite Stapel bildet zusammen mit einem Stapel von Elektrodenschichten, die auf einer Stirnfläche aus dem Grundkörper herausgeführt sind, einen zweiten Vielschichtkondensator.

Zur weiteren Erhöhung der Integrationsdichte ist es vorteilhaft, wenn weitere Vielschichtkondensatoren gebildet sind. Diese weiteren Vielschichtkondensator können vorteilhafterweise entlang der gegenüberliegenden Seitenflächen angeordnet sein, wobei die Kontakte jeweils auf gegenüberliegenden Seitenflächen liegen. Die zweiten Kontakte der weiteren Vielschichtkondensatoren können auf einer Stirnfläche des Grundkörpers liegen. Vorteilhafterweise sind die weiteren Vielschichtkondensatoren gebildet aus weiteren Stapeln von übereinanderliegenden Elektrodenschichten. Die weiteren Stapel sind dabei neben dem ersten beziehungsweise neben dem zweiten Stapel von Elektrodenschichten angeordnet und die Elektrodenschichten dieser Stapel sind wiederum auf gegenüberliegenden Seitenflächen des Grundkörpers aus diesem herausgeführt.

Desweiteren ist es vorteilhaft, wenn der zweite Kontakt eines Vielschichtkondensators von beiden Stirnflächen her kontaktiert werden kann. Dadurch können besondere Schaltungsvarianten realisiert werden, wobei ein Vielschichtkondensator von beiden Seiten her kontaktiert werden kann, beispielsweise zur Bildung einer gemeinsamen Erde mit weiteren Vielschichtkondensatoren.

In einer Ausführungsform der Erfindung ist jeder im Vielschichtbauelement enthaltene Vielschichtkondensator gebildet mittels eines Stapels von Elektrodenschichten, die beiderseits auf zwei gegenüberliegenden Stirnseiten des Grundkörpers herausgeführt sind.

Diese Ausführungsform hat den Vorteil, daß ein Kondensatoranschluß, der allen Kondensatoren gemeinsam ist in Richtung des Grundkörpers durch das Vielschichtbauelement durchgeführt werden kann, was wiederum den Aufwand für die äußere Beschaltung des Vielschichtbauelements reduziert.

Weiterhin ist es vorteilhaft, wenn zwei Vielschichtkondensatoren Kontakte aufweisen, die auf gegenüberliegenden Stirnflächen liegen, wodurch beispielsweise eine Erdung nebeneinander liegender Kondensatoren mit einer Stirnfläche und gleichzeitig eine Erdung der auf der gegenüberliegenden Seite angeordneten Vielschichtkondensatoren mit der gegenüberliegenden Stirnfläche möglich wird.

In einer weiteren Ausführungsform der Erfindung weist der Grundkörper zwei verschiedene Stapel von übereinanderliegenden Elektrodenschichten auf, die auf gegenüberliegenden Stirnseiten aus dem Grundkörper herausgeführt sind. Die beiden Stapel sind elektrisch gegeneinander isoliert. Mit Hilfe dieser Ausführungsform gelingt es, im Vielschichtbauelement integrierte Vielschichtkondensatoren zu Gruppen zusammenzufassen, die jeweils über einen gemeinsamen Kontakt intern miteinander verschaltet sind.

Beispielsweise können diejenigen Vielschichtkondensatoren einen gemeinsamen Kontakt aufweisen, welche entlang einer Seitenfläche nebeneinander angeordnet sind. Dann enthalten entlang einer Seitenfläche nebeneinander angeordnete Vielschichtkondensatoren einen Stapel von übereinanderliegenden Elektrodenschichten, die nur auf einer Stirnseite aus dem Grundkörper herausgeführt sind.

Ebenso können auch die entlang der gegenüberliegenden Seitenfläche nebeneinander angeordneten Vielschichtkondensatoren einen Stapel von übereinanderliegenden Elektrodenschichten enthalten, die nur auf der gegenüberliegenden Stirnfläche aus dem Grundkörper herausgeführt sind.

Die entlang jeweils einer Seitenfläche angeordneten Vielschichtkondensatoren können jeweils die gleiche Kapazität aufweisen. In einer anderen Ausführungsform der Erfindung können die Vielschichtkondensatoren auch unterschiedliche Kapazitäten aufweisen. Falls einander gegenüberliegende Kondensatoren die gleiche Kapazität aufweisen, ist es möglich, ein symmetrisches Bauelement zu realisieren.

In einer anderen Ausführungsform der Erfindung weisen die entlang der ersten Seitenfläche angeordneten Vielschichtkondensatoren eine größere Kapazität auf, als die entlang der zweiten Seitenfläche angeordneten Vielschichtkapazitäten. In einer anderen Ausführungsform der Erfindung steigt die Kapazität von entlang einer Seitenfläche angeordneten Kondensatoren in Längsrichtung des Grundkörpers monoton an oder sie fällt monoton ab.

In einer besonderen Ausführungsform der Erfindung enthalten die Dielektrikumsschichten ein Keramikmaterial mit Varistoreffekt. In Betracht kommen beispielsweise Keramikmaterialien auf der Basis von ZnO-Bi oder ZnO-Pr.

In einer anderen Ausführungsform der Erfindung können die Dielektrikumsschichten eine Kondensatorkeramik auf der Basis von Bariumtitanat enthalten. Als Dielektrikumsschicht kommt beispielsweise eine sogenannte "COG"-Keramik in Betracht. Ein solches Material wäre beispielsweise eine (Sm, Pa) NdCiO₃-Keramik. Es kommt aber auch eine "X7R"-Keramik in Betracht, beispielsweise dotiertes Bariumtitanat.

Der Grundkörper kann eine Grundfläche aufweisen, die kleiner als 2,5 mm² ist und dabei mindestens vier Vielschichtkondensatoren enthalten.

Es ist auch möglich, den Grundkörper so auszubilden, daß seine Grundfläche eine Fläche von maximal 5,2 mm² mißt. Dann enthält das Vielschichtbauelement mindestens acht Vielschichtkondensatoren.

Es ist darüber hinaus auch möglich, die Grundfläche des Grundkörpers so auszubilden, daß sie kleiner als 8 mm² ist. Dann können mindestens acht, zehn oder sogar zwölf Vielschichtkondensatoren in das Bauelement integriert werden.

Im folgenden wird die Erfindung anhand von Ausführungsbeispielen und den dazugehörigen Figuren näher erläutert.
- Figur 1: zeigt einen Längsschnitt durch ein beispielhaftes elektrisches Vielschichtbauelement in einer schematischen, nicht maßstabsgetreuen Darstellung.
- Figur 2: zeigt einen Querschnitt entlang der Linie II-II des Bauelement aus Figur 1.
- Figur 3: zeigt ein Ersatzschaltbild für das Bauelement aus Figur 1.
- Figur 4: zeigt ein weiteres beispielhaftes elektrisches Vielschichtbauelement in einem schematischen Längsschnitt.
- Figur 5: zeigt einen Querschnitt durch das Bauelement aus Figur 4 entlang der Linie V-V.
- Figur 6: zeigt ein weiteres beispielhaftes elektrisches Vielschichtbauelement in einem schematischen Längsschnitt.
- Figur 7: zeigt einen Querschnitt des Bauelements aus Figur 6 entlang der Linie VII-VII.
- Figur 8: zeigt beispielhaft ein weiteres elektrisches Vielschichtbauelement in einem schematischen Längsschnitt.
- Figur 9: zeigt einen Querschnitt durch das Bauelement aus Figur 8 entlang der Linie IX-IX.
- Figur 10: zeigt ein weiteres beispielhaftes elektrisches Vielschichtbauelement in einem schematischen Längsschnitt.
- Figur 11: zeigt einen Querschnitt durch das Bauelement aus Figur 10 entlang der Linie XI-XI.
- Figur 12: zeigt ein weiteres elektrisches Vielschichtbauelement in einem schematischen Längsschnitt.
- Figur 13: zeigt ein weiteres beispielhaftes elektrisches Vielschichtbauelement in einem schematischen Längsschnitt.
- Figur 14: zeigt ein Ersatzschaltbild für ein elektrisches Vielschichtbauelement gemäß Figur 13 für den Fall, daß für die Dielektrikumsschichten eine Varistorkeramik verwendet wird.

Figur 1 zeigt den Grundkörper 1 eines elektrischen Vielschichtbauelements. Das Bauelement ist dabei längs durchgeschnitten und es ist die Draufsicht auf Elektrodenschichten 4 zu sehen, die teils in einer Ebene liegen (markiert mit 51, 52, 53, 54) beziehungsweise teils in einer darunterliegenden, im wesentlichen parallelen Ebene angeordnet sind (markiert mit 50). Die Elektrodenschichten 4 können z. B. aus Ag, Pd, Pt oder auch aus einer Legierung aus Ag und Pt bzw. aus Ag und Pd bestehen bzw. solche Metalle enthalten. Sie können aber auch Cu oder Ni enthalten.

Es sind Stapel 50, 51, 52, 53, 54 von übereinanderliegenden Elektrodenschichten 4 in einer Draufsicht gezeigt. Die Elektrodenschichten 4 des Stapels 51 sind an der ersten Seitenfläche 61 am ersten Kontakt 81 aus dem Grundkörper 1 herausgeführt. Der Grundkörper 1 weist eine Grundfläche A auf. Die Elektrodenschichten 4 des Stapels 52 sind an einem Kontakt 82 auf der der Seitenfläche 61 gegenüberliegenden Seitenfläche 62 aus dem Grundkörper 1 herausgeführt. Dadurch sind einander gegenüberliegende Vielschichtkondensatoren C1, C2 realisiert. Die Gegenelektroden der Vielschichtkondensatoren C1, C2 werden dabei gebildet durch Elektrodenschichten 4, welche als Stapel 50 übereinanderliegen und welche zu beiden Seiten auf jeder Stirnseite 71, 72 aus dem Grundkörper 1 des Bauelements herausgeführt sind. Die Elektrodenschichten 4 des Stapels 50 sind dabei mit auf den Stirnflächen 71, 72 angeordneten Kontakten 80, 89 elektrisch kontaktiert. Es sind in Längsrichtung neben den Vielschichtkondensatoren C1 und C2 noch die Vielschichtkondensatoren C3 beziehungsweise C4 angeordnet. Die Vielschichtkondensatoren C3 und C4 sind ebenso wie die Vielschichtkondensatoren C1 und C2 gebildet aus Stapeln 53, 54 von übereinanderliegenden Elektrodenschichten 4, die jeweils auf gegenüberliegenden Seitenflächen 61, 62 aus dem Grundkörper 1 herausgeführt sind. Im einzelnen sind die Elektrodenschichten 4 des Stapels 53 mit dem Kontakt 83 auf der ersten Seitenfläche 61 des Grundkörpers 1 kontaktiert. Die Elektrodenschichten 4 des Stapels 54 sind mit dem Kontakt 84 auf der der ersten Seitenfläche 61 gegenüberliegenden Seitenfläche 62 verbunden. Indem die Elektrodenschichten 4 des Schichtstapels 50 eine gemeinsame Gegenelektrode für alle Vielschichtkondensatoren C1 C2, C3, C4 bilden, kann ein Bauelement realisiert werden, für das das in Figur 3 gezeigte Ersatzschaltbild gilt. Die Vielschichtkondensatoren sind also bereits intern miteinander verschaltet, wobei aufgrund der Varistor-Dielektrikumsschichten jeweils eine Parallelschaltung zwischen einem Kondensator C1 C2, C3, C4 und einem Varistor V1, V2, V3 und V4 resultiert.

Die Seitenflächen 61, 62 verlaufen entlang einer Längsrichtung. Die Längsrichtung ist durch den Pfeil angegeben.

In Figur 2 sind die Schichtstapel 50, 51, 52 in einem Querschnitt zu sehen. Die Elektrodenschichten 4 sind dabei zwischen Dielektrikumsschichten 3 angeordnet. Das erfindungsgemäße Vielschichtbauelement kann vorteilhafterweise hergestellt werden durch Übereinanderstapeln von keramischen Grünfolien und geeigneten Elektrodenschichten, anschließendem Verpressen und Sintern des Schichtstapels. Durch Gemeinsamsinterung wird sowohl eine hohe mechanische Stabilität als auch gute elektrische Eigenschaften realisiert. Die Außenkontakte 81, 82 können beispielsweise mittels Silbereinbrennpaste an den Außenflächen des Grundkörpers 1 realisiert werden. Indem die Kontakte 81, 82 kappenartig über die Seitenflächen 61, 62 greifen, kann ein SMD-fähiges Bauelement realisiert werden. Aus Figur 2 geht auch hervor, daß die Elektrodenschichten 4 der Schichtstapel 51 und 52 innerhalb des Bauelements elektrisch voneinander isoliert sind. Daher werden zwei verschiedene Vielschichtkondensatoren durch die Schichtstapel 51, 52 gebildet.

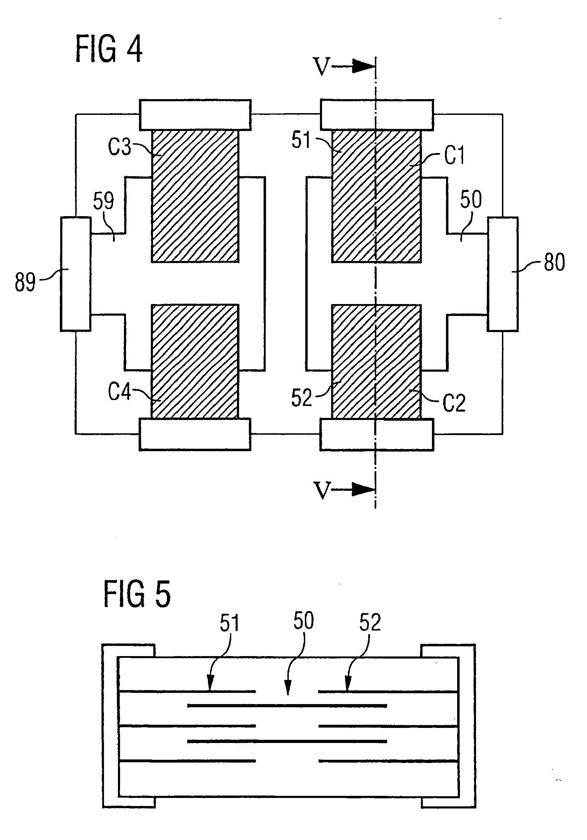

Figur 4 zeigt ein elektrisches Vielschichtbauelement entsprechend Figur 1, jedoch mit dem Unterschied, daß die als Gegenelektrode ausgeführten Elektrodenschichten in zwei verschiedenen Schichtstapeln 50, 59 angeordnet sind. Die Elektrodenschichten des Schichtstapels 50 sind dabei auf der ersten Stirnfläche mit einem Kontakt 80 aus dem Grundkörper herausgeführt. Die Elektrodenschichten des zweiten Schichtstapels 59 sind auf der gegenüberliegenden Stirnfläche mit Hilfe des Kontakts 89 aus dem Grundkörper herausgeführt. In Längsrichtung des Bauelements sind die Elektrodenschichten der Stapel 50 und 59 innerhalb des Bauelements elektrisch voneinander isoliert.

Indem die Vielschichtkondensatoren C1, C2, C3, C4 mit Hilfe von verschiedenen Stapeln 50, 59 aus Elektrodenschichten gebildet werden, kann eine von Figur 3 verschiedene Verschaltung der Vielschichtkondensatoren C1, C2, C3, C4 realisiert werden, was je nach Anwendungsfall zweckmäßig ist.

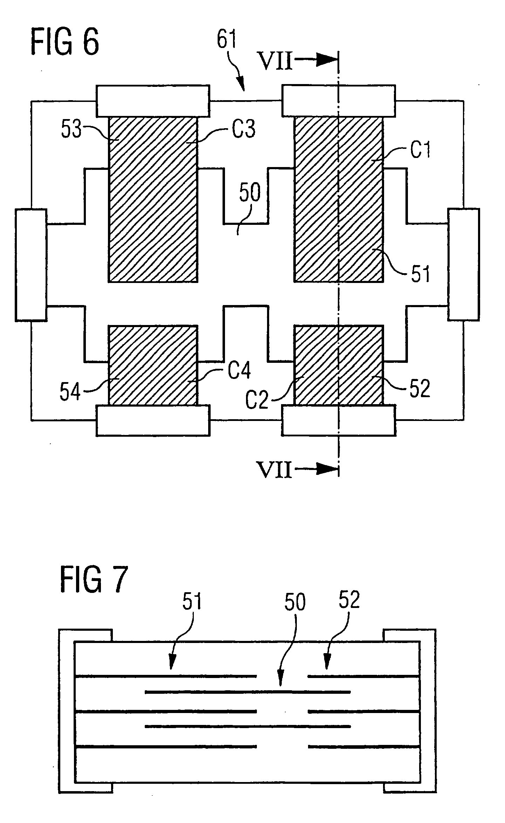

Figur 5 zeigt den Querschnitt von Figur 4 in analoger Weise zu Figur 2. Es sind die Stapel 50, 51, 52 von übereinanderliegenden Elektrodenschichten dargestellt.

Figur 6 zeigt ein Vielschichtbauelement entsprechend Figur 1 mit dem Unterschied, daß die Elektrodenschichten der Schichtstapel 51, 53 in der Fläche größer ausgeführt sind, als die analogen Schichtstapel in Figur 1. Demgegenüber sind die Elektrodenschichten der Schichtstapel 52 und 54 kleiner ausgeführt als die entsprechenden Elektrodenschichten in Figur 1. Dadurch kann es erreicht werden, daß die Vielschichtkondensatoren C1 und C3 eine größere Kapazität aufweisen, als die Vielschichtkondensatoren C2 und C4, was je nach Anwendungsfall für das Vielschichtbauelement von Vorteil ist.

Figur 7 zeigt den Querschnitt zu Figur 6, wobei die Stapel 50, 51, 52 dargestellt sind.

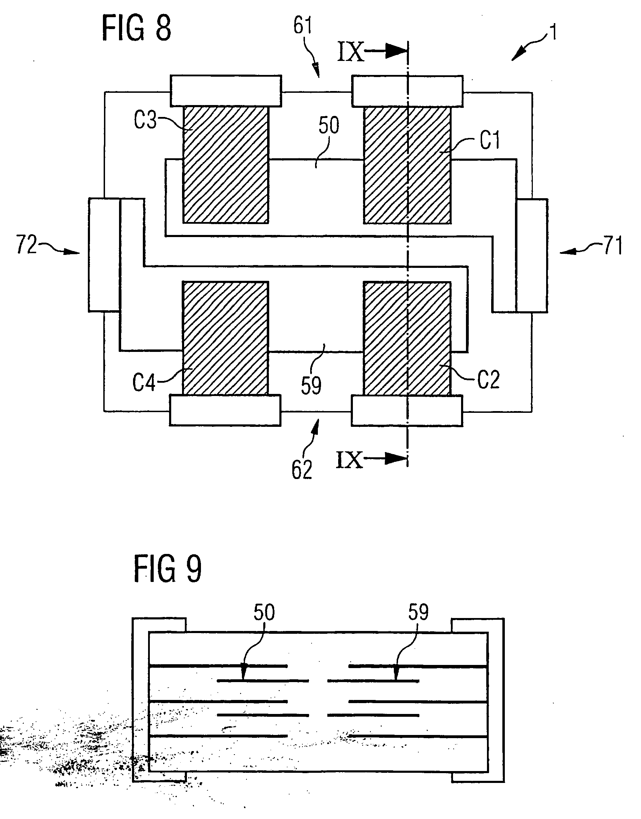

Figur 8 zeigt ein Vielschichtbauelement entsprechend Figur 4 mit dem Unterschied, daß die mit dem gemeinsamen Schichtstapel 50 gebildeten Vielschichtkondensatoren C1 C3 nicht einander gegenüberliegend sondern entlang einer ersten Seitenfläche 61 nebeneinander angeordnet sind. Dementsprechend sind die mit dem Schichtstapel 59 gebildeten Vielschichtkondensatoren C2 und C4 entlang der zweiten Seitenfläche 62 nebeneinander angeordnet. Dies wird realisiert, indem entsprechend gestaltete Vielschichtelektroden einen Stapel 50 bilden, wobei die Elektrodenschichten an der ersten Stirnfläche 71 aus dem Grundkörper 1 herausgeführt sind. In analoger Weise sind Elektrodenschichten, die einen Stapel 59 von Elektrodenschichten bilden, auf der gegenüberliegenden Stirnfläche 72 aus dem Grundkörper 1 herausgeführt. Die Elektrodenschichten der Stapel 50 und 59 sind innerhalb des Vielschichtbauelements allseitig gegeneinander isoliert. Dies geht auch hervor aus Figur 9, welche einen entsprechenden Querschnitt zeigt, und wo zu erkennen ist, daß die Elektrodenschichten der Stapel 50 und 59 voneinander isoliert sind, das heißt, daß die Elektrodenschichten in der Mitte des Bauelements unterbrochen sind.

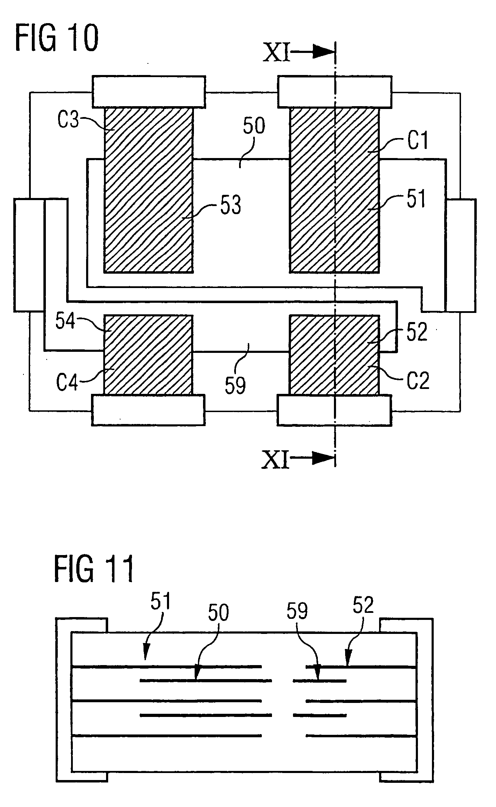

Figur 10 zeigt ein Vielschichtbauelement entsprechend Figur 8, mit dem Unterschied, daß die Elektrodenschichten der Stapel 51 und 53 größer ausgeführt sind, als die entsprechenden Elektrodenschichten in Figur 8. Weiterhin sind die Elektrodenschichten der Stapel 52 und 54 kleiner ausgeführt als die entsprechenden Elektrodenschichten in Figur 8. Dadurch wird es erreicht, ein Vielschichtbauelement zu realisieren, bei dem die Kapazitäten der Vielschichtkondensatoren C1 und C3 größer sind als die Kapazitäten der Vielschichtkondensatoren C2 und C4.

Figur 11 zeigt entsprechend Figur 9 wieder den dazugehörigen Querschnitt.

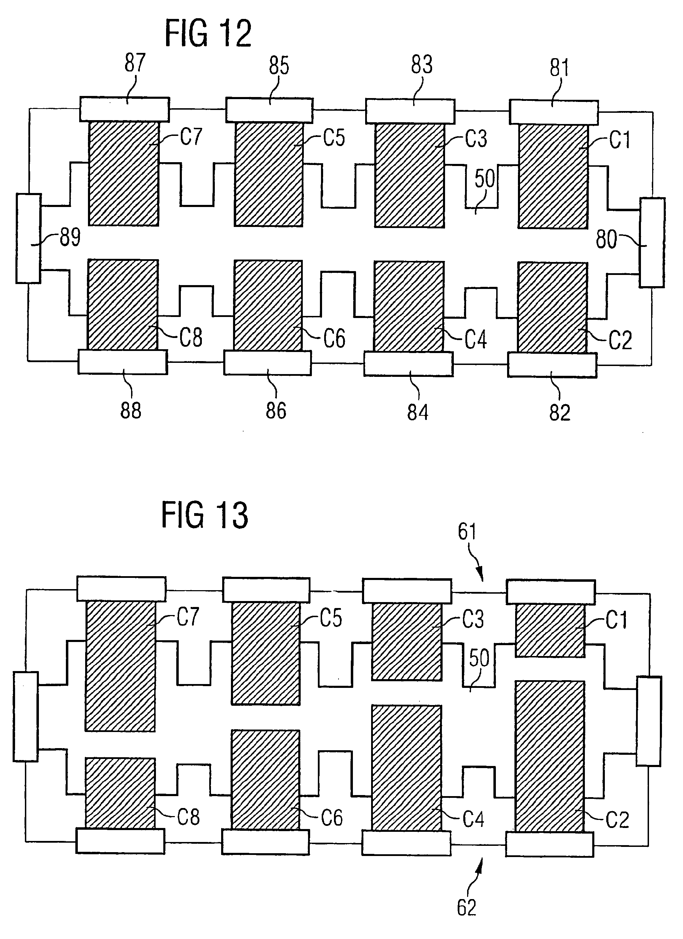

Figur 12 zeigt ein weiteres Vielschichtbauelement, das entsprechend Figur 1 ausgeführt ist, jedoch mit dem Unterschied, daß nicht vier Vielschichtkondensatoren sondern acht Vielschichtkondensatoren C1, C2, C3, C4, C5, C6, C7, C8 innerhalb des Bauelements angeordnet sind. Die Vielschichtkondensatoren C1 bis C8 sind mit entsprechenden Kontakten 81, 82, 83, 84, 85, 86, 87, 88 an den Außenflächen des Grundkörpers verbunden. Die Kondensatoren C1 bis C8 sind gebildet mit Hilfe eines Stapels 50 von übereinanderliegenden Elektrodenschichten, die allen Vielschichtkondensatoren C1 bis C8 gemeinsam sind. Die Elektrodenschichten des Stapels 50 sind auf beiden einander gegenüberliegenden Stirnseiten des Grundkörpers 1 mit Kontakten 80, 89 aus diesem herausgeführt.

Figur 13 zeigt ein Vielschichtbauelement entsprechend Figur 12 mit dem Unterschied, daß die Kapazität der Vielschichtkondensatoren C7, C5, C3, C1 in dieser Reihenfolge stetig abnimmt. Entsprechend nimmt die Kapazität der Vielschichtkondensatoren C8, C6, C4, C2 in Längsrichtung des Bauelements zu.

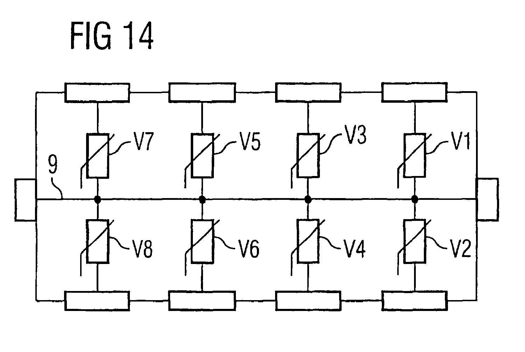

Figur 14 zeigt ein Ersatzschaltbild für ein Vielschichtbauelement nach Figur 12 für den Fall, daß für die Dielektrikumsschichten eine Varistorkeramik verwendet wird. Dann entsteht gemäß Figur 14 ein Bauelement mit Varistoren V1, V2, V3, V4, V5, V6, V7, V8, welche durch eine gemeinsame Mittelelektrode 9 miteinander verschaltet sind.

Durch Verwenden eines geeigneten Keramikmaterials für die Dielektrikumsschichten wird aus dem Vielschichtkondensator ein Vielschichtvaristor. Ebenso können durch Auswahl geeigneter Keramikmaterialien für die Dielektrikumsschichten noch weitere Vielschichtbauelemente realisiert werden, so daß die vorliegende Erfindung nicht beschränkt ist auf Vielschichtkondensatoren im strengen Sinne, sondern lediglich darauf, daß ein keramisches Vielschichtbauelement nach der Bauweise der Vielschichtkondensatoren, das heißt also durch kammartig ineinandergreifende flächenartige Elektrodenstrukturen gebildet ist.

### Bezugszeichenliste

- 1: Grundkörper
- 2: Stapel
- 3: Dielektrikumsschicht
- 4: Elektrodenschicht
- 50, 51, 52, 53, 54, 55, 56, 57, 58, 59: Stapel
- 61, 62: Seitenfläche
- 71, 72: Stirnfläche
- 80, 81, 82, 83, 84, 85, 86, 87, 88, 89: Kontakt
- C1 C2, C3, C4, C5, C6, C7, C8: Vielschichtkondensator
- V1, V2, V3, V4, V5, V6, V7, V8: Vielschichtvaristor
- A: Grundfläche
- 9: Mittelelektrode

## Patentansprüche

1. Vielschichtbauelement
- mit einem Grundkörper (1) enthaltend einen Stapel (2) aus übereinander liegenden Dielektrikumsschichten (3) mit dazwischenliegenden Elektrodenschichten (4),
- wobei die Dielektrikumsschichten (3) ein Keramikmaterial mit Varistoreffekt enthalten,
- bei dem der Grundkörper (1) entlang einer Längsrichtung verlaufende, gegenüberliegende Seitenflächen (61, 62) sowie Stirnflächen (71, 72) aufweist,
- mit mehreren Vielschichtkondensatoren (C1, C2, C3, C4, C5, C6, C7, C8), wobei
- ein erster elektrischer Kontakt (81) eines jeden Vielschichtkondensators auf einer Seitenfläche (61) des Vielschichtbauelements, und
- ein zweiter elektrischer Gegenkontakt (80, 89) eines jeden Vielschichtkondensators auf einer Stirnfläche (71, 72) des Vielschichtbauelements angeordnet ist, und
- die ersten elektrischen Kontakte von zumindest zwei Vielschichtkondensatoren auf gegenüberliegenden Seitenflächen angeordnet sind, und
- wobei der zweite elektrische Gegenkontakt eines jeden Vielschichtkondensators nur auf einem Teilbereich der gesamten Stirnfläche angeordnet ist,
- jeder Vielschichtkondensator mehrere mit seinem ersten elektrischen Kontakt kontaktierte, übereinander angeordnete Elektrodenschichten aufweist.

2. Vielschichtbauelement nach Anspruch 1, bei dem zumindest zwei der Vielschichtkondensatoren (C1, C2, C3, C4, C5, C6, C7, C8) sich in Querrichtung gegenüberliegen.

3. Vielschichtbauelement nach einem der Ansprüche 1 oder 2, bei dem zumindest zwei der Vielschichtkondensatoren (C1, C2, C3, C4, C5, C6, C7, C8) in Längsrichtung nebeneinander angeordnet sind.

4. Vielschichtbauelement nach einem der vorhergehenden Ansprüche, bei dem die Elektrodenschichten benachbarter Vielschichtkondensatoren (C1, C2, C3, C4, C5, C6, C7, C8) in einer Ebene liegen.

5. Vielschichtbauelement nach einem der vorhergehenden Ansprüche,
bei dem der zweite elektrische Gegenkontakt (80, 89) eines Vielschichtkondensators (C1, C2, C3, C4, C5, C6, C8) von beiden Stirnflächen (71, 72) her kontaktierbar ist.

6. Vielschichtbauelement nach einem der vorhergehenden Ansprüche, bei dem
- ein Stapel von Dielektrikumsschichten,
- ein im Grundkörper (1) angeordneter Stapel (51, 52, 53, 54) von übereinander liegenden Elektrodenschichten (4), die auf einer Seitenfläche (61, 62) des Vielschichtbauelements aus dem Grundkörper herausgeführt sind, und
- ein Stapel (50, 59) von Gegenelektrodenschichten, die auf einer Stirnfläche (71, 72) herausgeführt sind,
einen Vielschichtkondensator (C1 C2, C3, C4, C5, C6, C8)) bilden.

7. Vielschichtbauelement nach Anspruch 6, bei dem die zweite elektrische Gegenelektrodenschicht (50) eines Vielschichtkondensators (C1, C2, C3, C4, C5, C6, C8) auf jeder Stirnseite (71, 72) aus dem Grundkörper (1) herausgeführt ist.

8. Vielschichtbauelement nach einem der vorhergehenden Ansprüche;
bei dem die entlang jeweils einer Seitenfläche (61, 62) angeordneten Vielschichtkondensatoren (C1, C3; C2, C4) die gleiche Kapazität aufweisen.

9. Vielschichtbauelement nach einem der vorhergehenden Ansprüche,
bei dem die entlang der ersten Seitenfläche (61) angeordneten Vielschichtkondensatoren (C1, C3) eine größere Kapazität aufweisen als die entlang der zweiten Seitenfläche (62) angeordneten Vielschichtkondensatoren (C2, C4).

10. Vielschichtbauelement nach einem der vorhergehenden Ansprüche,
bei dem die Kapazität von entlang einer Seitenfläche (61) angeordneten Vielschichtkondensatoren (C1 C3, C5, C7) in Längsrichtung des Grundkörpers (1) monoton steigt oder fällt.

11. Vielschichtbauelement nach einem der vorhergehenden Ansprüche,
bei dem die Dielektrikumsschichten (3) ZnO-Bi oder ZnO-Pr enthalten.

12. Vielschichtbauelement nach einem der Ansprüche 1 bis 10, bei dem die Dielektrikumsschichten (3) eine Kondensatorkeramik auf der Basis von Bariumtitanat enthalten.

13. Vielschichtbauelement nach einem der vorhergehenden Ansprüche,
bei dem der Grundkörper (1) eine Grundfläche (A) aufweist, die kleiner ist als 2,5 mm² und der mindestens vier Vielschichtkondensatoren enthält.

14. Vielschichtbauelement nach einem der Ansprüche 1 bis 12, bei dem der Grundkörper (1) eine Grundfläche (A) aufweist, die kleiner als 5,2 mm² ist und der mindestens acht Vielschichtkondensatoren enthält.

15. Vielschichtbauelement nach einem der Ansprüche 1 bis 12, bei dem der Grundkörper (1) eine Grundfläche (A) aufweist, die kleiner als 8 mm² ist und der mindestens acht, zehn oder zwölf Vielschichtkondensatoren enthält.

16. Vielschichtbauelement nach einem der vorhergehenden Ansprüche,
bei dem die Elektrodenschichten (4) Ag, Pd, Pt, Cu, Ni oder eine Legierung aus Ag und Pd oder aus Ag und Pt enthalten.

## Claims

1. Multilayer component
- comprising a base body (1) containing a stack (2) of dielectric layers (3 lying on top of one another with interposed electrode layers (4),
- whereby the dielectric layers (3) contain a ceramic material with a varistor effect,
- in which the base body (1) comprises end surfaces (71, 72) and opposite side surfaces (61, 62) running in a longitudinal direction,
- comprising a plurality of multilayer capacitors (C1, C2, C3, C4, C5, C6, C7, C8), whereby
- a first electrical contact (81) of each multilayer capacitor is arranged on a side surface (61) of the multilayer component, and
- a second electrical counter-contact (80, 89) of each multilayer capacitor is arranged on an end surface (71, 72) of the multilayer component, and
- the first electrical contacts of at least two multilayer capacitors are arranged on opposite side surfaces, and whereby
- the second electrical counter-contact of each multilayer capacitor is arranged only in a partial region of the entire end surface,
- each multilayer capacitor comprises a plurality of electrode layers arranged on top of one another which are contacted to its first electrical contact.

2. Multilayer component according to Claim 1, in which at least two of the multilayer capacitors (C1, C2, C3, C4, C5, C6, C7, C8) lie opposite one another in a transverse direction.

3. Multilayer component according to either of Claims 1 and 2, in which at least two of the multilayer capacitors (C1, C2, C3, C4, C5, C6, C7, C8) are arranged beside one another in a longitudinal direction.

4. Multilayer component according to one of the preceding claims, in which the electrode layers of adjacent multilayer capacitors (C1, C2, C3, C4, C5, C6, C7, C8) are located in one plane.

5. Multilayer component according to one of the preceding claims, in which the second electrical counter-contact (80, 89) of a multilayer capacitor (C1, C2, C3, C4, C5, C6, C8) is contactable from both end surfaces (71, 72).

6. Multilayer component according to one of the preceding claims, in which
- a stack of dielectric layers,
- a stack (51, 52, 53, 54), arranged in the base body (1), of electrode layers (4) lying on top of one another are led out of the base body on a side surface (61, 62) of the multilayer component, and
- a stack (50, 59) of counterelectrode layers which are led out on an end surface (71, 72)
form a multilayer capacitor (C1, C2, C3, C4, C5, C6, C8).

7. Multilayer component according to Claim 6, in which the second electrical counterelectrode layer (50) of a multilayer capacitor (C1, C2, C3, C4, C5, C6, C8) is led out of the base body (1) on each end side (71, 72).

8. Multilayer component according to one of the preceding claims, in which the multilayer capacitors (C1, C3; C2, C4) arranged along a respective side surface (61, 62) have the same capacitance.

9. Multilayer component according to one of the preceding claims, in which the multilayer capacitors (C1, C3) arranged along the first side surface (61) have a greater capacitance than the multilayer capacitors (C2, C4) arranged along the second side surface (62).

10. Multilayer component according to one of the preceding claims, in which the capacitance of multilayer capacitors (C1, C3, C5, C7) arranged along a side surface (61) monotonously rises or falls in the longitudinal direction of the base body (1).

11. Multilayer component according to one of the preceding claims, in which the dielectric layers (3) contain ZnO-Bi or ZnO-Pr.

12. Multilayer component according to one of Claims 1 to 10, in which the dielectric layers (3) contain a capacitor ceramic based on barium titanate.

13. Multilayer component according to one of the preceding claims, in which the base body (1) has a base area (A) smaller than 2.5 mm² and contains at least four multilayer capacitors.

14. Multilayer component according to one of Claims 1 to 12, in which the base body (1) has a base area (A) smaller than 5.2 mm² and contains at least eight multilayer capacitors.

15. Multilayer component according to one of Claims 1 to 12, in which the base body (1) has a base area (A) smaller than 8 mm² and contains at least eight, ten or twelve multilayer capacitors.

16. Multilayer component according to one of the preceding claims, in which the electrode layers (4) contain Ag, Pd, Pt, Cu, Ni or an alloy of Ag and Pd or Ag and Pt.

## Revendications

1. Composant multicouche
- comprenant un corps (1) de base contenant une pile (2) de couches (3) de diélectrique superposées ayant des couches (4) d'électrode interposées,
- les couches (3) de diélectrique contenant un matériau céramique ayant un effet de varistance,
- dans lequel le corps (1) de base a des surfaces (61, 62) latérales opposées s'étendant dans une direction longitudinale ainsi que des surfaces (71, 72) frontales,
- comprenant plusieurs condensateurs (C1, C2, C3, C4, C5, C6, C7, C8) multicouches, dans lequel
- un premier contact (81) électrique de l'un de chaque condensateur multicouche est disposé sur une surface (61) latérale du composant multicouche et
- un deuxième contre-contact (80, 89) électrique d'un de chaque condensateur multicouche est disposé sur une surface (71, 72) frontale du composant multicouche et
- les premiers contacts électriques d'au moins deux condensateurs multicouches sont disposés sur des surfaces latérales opposées et
- dans lequel le deuxième contre-contact électrique d'un de chaque condensateur multicouche n'est disposé que sur une zone partielle de toute la surface frontale,
- chaque condensateur multicouche ayant plusieurs couches d'électrode superposées et mises en contact par son premier contact électrique.

2. Composant multicouche selon la revendication 1, dans lequel au moins deux des condensateurs (C1, C2, C3, C4, C5, C6, C7, C8) multicouches sont opposés dans la direction transversale.

3. Composant multicouche selon l'une des revendications 1 ou 2, dans lequel au moins deux des condensateurs (C1, C2, C3, C4, C5, C6, C7, C8) multicouches sont disposés côte à côte dans la direction longitudinale.

4. Composant multicouche selon l'une des revendications précédentes, dans lequel les couches d'électrode des condensateurs (C1, C2, C3, C4, C5, C6, C7, C8) multicouches voisins sont dans un plan.

5. Composant multicouche selon l'une des revendications précédentes,
dans lequel le deuxième contre-contact (80, 89) électrique d'un condensateur (C1, C2, C3, C4, C5, C6, C8) multicouche peut être mis en contact à partir de deux surfaces (71, 72) frontales.

6. Composant multicouche selon l'une des revendications précédentes, dans lequel
- une pile de couches de diélectrique,
- une pile (51, 52, 53, 54) disposée dans le corps (1) de base de couches (4) d'électrode superposées, qui sont sorties du corps de base sur une surface (61, 62) latérale du composant multicouche et
- une pile (50, 59) de couches de contre-électrodes qui sont sorties sur une surface (71, 72) frontale, forment un condensateur (C1, C2, C3, C4, C5, C6, C8) multicouche.

7. Composant multicouche selon la revendication 6, dans lequel la deuxième couche (50) de contre-électrode électrique d'un condensateur (C1, C2, C3, C4, C5, C6, C8) multicouche est sortie sur chaque côté (71, 72) frontal du corps (1) de base.

8. Composant multicouche selon l'une des revendications précédentes,
dans lequel les condensateurs (C1, C3 ; C2, C4) multicouches disposés le long respectivement d'une surface (61, 62) frontale ont la même capacité.

9. Composant multicouche selon l'une des revendications précédentes,
dans lequel les condensateurs (C1, C3) multicouches disposés le long de la première surface (61) latérale ont une capacité plus grande que les condensateurs (C2, C4) multicouches disposés le long de la deuxième surface (62) latérale.

10. Composant multicouche selon l'une des revendications précédentes,
dans lequel la capacité de condensateurs (C1, C3, C5, C7) multicouches disposés le long d'une surface (61) latérale augmente ou diminue de façon monotone dans la direction longitudinale du corps (1) de base.

11. Composant multicouche selon l'une des revendications précédentes,
dans lequel les couches (3) de diélectrique contiennent du ZnO-Bi ou du ZnO-Pr.

12. Composant multicouche selon l'une des revendications 1 à 10, dans lequel les couches (3) de diélectrique contiennent une céramique de condensateur à base de titanate de baryum.

13. Composant multicouche selon l'une des revendications précédentes,
dans lequel le corps (1) de base a une surface (A) de base qui est plus petite que 2,5 mm² et qui contient au moins quatre condensateurs multicouches.

14. Composant multicouche selon l'une des revendications 1 à 12, dans lequel le corps (1) de base a une surface (A) de base qui est plus petite que 5,2 mm² et qui contient au moins huit condensateurs à couches multiples.

15. Composant multicouche selon l'une des revendications 1 à 12, dans lequel le corps (1) de base une surface (A) de base qui est plus petite que 8 mm² et qui contient au moins huit, dix ou douze condensateurs à couches multiples.

16. Composant multicouche selon l'une des revendications précédentes,
dans lequel les couches (4) d'électrode contiennent de l'Ag, du Pd, du Pt, du Cu, du Ni ou d'un alliage en Ag et Pd ou en Ag et Pt.
